(19) Europäisches Patentamt / European Patent Office / Office européen des brevets

(11) **EP 4 607 501 A1**

(12) **EUROPEAN PATENT APPLICATION**
published in accordance with Art. 153(4) EPC

(43) Date of publication:
**27.08.2025 Bulletin 2025/35**

(21) Application number: **23879178.4**

(22) Date of filing: **19.10.2023**

(51) International Patent Classification (IPC):
**G10H 1/36** (2006.01)

(52) Cooperative Patent Classification (CPC):
**G10H 1/36; G11B 27/10; G11C 7/16**

(86) International application number:
**PCT/CN2023/125428**

(87) International publication number:
**WO 2024/083192 (25.04.2024 Gazette 2024/17)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **19.10.2022 CN 202211280550**

(71) Applicant: **Beijing Zitiao Network Technology Co., Ltd.**
**Beijing 100190 (CN)**

(72) Inventor: **SHI, Lei**
**Beijing 100028 (CN)**

(74) Representative: **Marks & Clerk LLP**
**15 Fetter Lane**
**London EC4A 1BW (GB)**

(54) **AUDIO PROCESSING METHOD AND APPARATUS, DEVICE, STORAGE MEDIUM, AND PROGRAM PRODUCT**

(57) Disclosed a method, an apparatus, a device, a storage medium and a program product for processing audio. The method includes: capturing an external sound to obtain a second audio during playing a first audio to the outside; determining a play duration of the first audio based on a current system time and a play latency; calculating a reference timestamp based on the play duration of the first audio and a capture latency; processing the second audio based on the reference timestamp to obtain a third audio; and performing audio mixing processing on the first audio and the third audio to obtain a target audio. According to the technical scheme provided by the disclosure, the influence of the time latency on the audio is optimized during mixing the first audio and the second audio, so that the played first audio and the recorded second audio are synchronized, the influence of the time latency on the audio listening is reduced, and the karaoke experience of the user is improved.

```
┌─────────────────────────────────────────────────────┐
│ CAPTURE AN EXTERNAL SOUND TO OBTAIN A SECOND AUDIO    │  S101
│ DURING PLAYING A FIRST AUDIO TO THE OUTSIDE           │
└─────────────────────────────────────────────────────┘
                          │
                          ▼
┌─────────────────────────────────────────────────────┐
│ DETERMINE A PLAY DURATION OF THE FIRST AUDIO BASED ON │  S102
│ A CURRENT SYSTEM TIME AND A PLAY LATENCY, WHEREIN THE  │
│ PLAY LATENCY IS A DURATION BETWEEN A STARTUP TIME OF   │
│ AN AUDIO PLAYER AND A TIME AT WHICH AN AUDIO IS OUTPUT │
│ BY THE AUDIO PLAYER                                    │
└─────────────────────────────────────────────────────┘
                          │
                          ▼
┌─────────────────────────────────────────────────────┐
│ CALCULATE A REFERENCE TIMESTAMP BASED ON THE PLAY     │  S103
│ DURATION OF THE FIRST AUDIO AND A CAPTURE LATENCY,     │
│ WHEREIN THE CAPTURE LATENCY COMPRISES A DURATION       │
│ BETWEEN A STARTUP TIME OF AN AUDIO COLLECTOR AND A     │
│ TIME AT WHICH THE SECOND AUDIO IS CAPTURED TO A FIRST  │
│ AUDIO FRAME                                            │
└─────────────────────────────────────────────────────┘
                          │
                          ▼
┌─────────────────────────────────────────────────────┐
│ PROCESS THE SECOND AUDIO BASED ON THE REFERENCE       │  S104
│ TIMESTAMP TO OBTAIN A THIRD AUDIO                      │
└─────────────────────────────────────────────────────┘
                          │
                          ▼
┌─────────────────────────────────────────────────────┐
│ PERFORM AUDIO MIXING PROCESSING ON THE FIRST AUDIO     │  S105
│ AND THE THIRD AUDIO TO OBTAIN A TARGET AUDIO           │
└─────────────────────────────────────────────────────┘
```

FIG. 1

EP 4 607 501 A1

## Description

This application claims the priority to Chinese Patent Application No. 202211280550.4, filed on Oct. 19, 2022 and entitled "Method, Apparatus, Device, Storage Medium, and Program Product of Audio Processing". The entirety of this Chinese patent application is incorporated herein by reference.

## FIELD

The present disclosure relates to the field of audio processing technologies, and in particular, to a method, an apparatus, a device, a storage medium, and a program product for processing audio.

## BACKGROUND

With the development of Internet technologies, many music players not only support online playing of massive songs, but also provide a karaoke service for users, wherein the karaoke service refers to a music accompaniment played by a music player, and a user may sing following the music accompaniment. During singing, the music player may also record the song sung by the user, so as to subsequently play the song sung by the user.

In the related art, the audio recording process is generally as follows: the terminal starts the music player to play the music accompaniment of the song, and when the user starts singing, the terminal synchronously starts recording to obtain the recorded audio. When recording ends, the terminal may perform audio mixing based on the music accompaniment and the recorded audio to obtain a completed song.

However, there may be a play latency when the terminal plays the music accompaniment, and there may be a capture latency in the process of recording the audio. Thus, there may be a large latency between the music accompaniment and the recorded audio. In the process of mixing the music accompaniment and the recorded audio, the music accompaniment and the recorded audio are not synchronized due to the large latency, the listening experience is seriously affected, and the user karaoke experience is poor.

## SUMMARY

In order to solve the technical problem, the disclosure provides a method, an apparatus, a device, and a storage medium for processing audio, which optimize the latency of recording in a background music scene, and solve the problem that the latency of recording is too long and the auditory effect is affected.

According to a first aspect, an embodiment of the present disclosure provides a method of processing audio, wherein the method comprises:

   capturing an external sound to obtain a second audio during playing a first audio to the outside;
   determining a play duration of the first audio based on a current system time and a play latency, wherein the play latency is a duration between a startup time of an audio player and a time at which an audio is output by the audio player;
   calculating a reference timestamp based on the play duration of the first audio and a capture latency, wherein the capture latency comprises a duration between a startup time of an audio collector and a time at which the second audio is captured to a first audio frame;
   processing the second audio based on the reference timestamp to obtain a third audio; and
   performing audio mixing processing on the first audio and the third audio to obtain a target audio.

According to a second aspect, an embodiment of the present disclosure provides an apparatus for processing video and audio, wherein the apparatus comprises:

   a second audio capturing module, configured to capture an external sound to obtain a second audio during playing a first audio to the outside;
   a play duration determining module, configured to determine a play duration of the first audio based on a current system time and a play latency, wherein the play latency is a duration between a startup time of an audio player and a time at which an audio is output by the audio player;
   a reference timestamp determining module, configured to calculate a reference timestamp based on the play duration of the first audio and a capture latency, wherein the capture latency comprises a duration between a startup time of an audio collector and a time at which the second audio is captured to a first audio frame;
   a third audio determining module, configured to process the second audio based on the reference timestamp to obtain a third audio; and

a target audio determining module, configured to perform audio mixing processing on the first audio and the third audio to obtain a target audio.

According to a third aspect, an embodiment of the present disclosure provides an electronic device, wherein the electronic device comprises:

one or more processors;
a storage device, configured to store one or more programs;
the one or more programs, when executed by the one or more processors, cause the one or more processors to implement the method of audio processing according to any of above first aspect.

According to a fourth aspect, an embodiment of the present disclosure provides a computer-readable storage medium having a computer program stored thereon, wherein the computer program, when executed by a processor, implements the method of audio processing according to any of above first aspect.

According to a fifth aspect, an embodiment of the present disclosure provides a computer program product, comprising a computer program or instructions, wherein the computer program or instructions, when executed by a processor, implements the method of audio processing according to any of above first aspect.

The disclosure relates to an audio processing method, apparatus, device, storage medium and program product. The method comprises: capturing an external sound to obtain a second audio during playing a first audio to the outside; determining a play duration of the first audio based on a current system time and a play latency, wherein the play latency is a duration between a startup time of an audio player and a time at which an audio is output by the audio player; calculating a reference timestamp based on the play duration of the first audio and a capture latency, wherein the capture latency comprises a duration between a startup time of an audio collector and a time at which the second audio is captured to a first audio frame; processing the second audio based on the reference timestamp to obtain a third audio; and performing audio mixing processing on the first audio and the third audio to obtain a target audio. According to the technical scheme provided by the disclosure, the influence of the latency on the audio is optimized during mixing the first audio and the second audio, so that the played first audio and the recorded second audio are synchronized, the influence of the latency on the audio listening is reduced, and the karaoke experience of the user is improved.

## BRIEF DESCRIPTION OF THE DRAWINGS

The above and other features, advantages, and aspects of various embodiments of this disclosure will become more apparent from the following detailed description taken in conjunction with the accompanying drawings. Throughout the drawings, the same or similar reference numbers refer to the same or similar elements. It should be understood that the drawings are schematic, and components and elements are not necessarily drawn to scale.

FIG. 1 is a schematic flowchart of a method of audio processing according to an embodiment of the present disclosure;
FIG. 2 is a schematic diagram of details of record latency according to an embodiment of the present disclosure;
FIG. 3 is a schematic diagram of a schema of alignment of background music and recording acquirement according to an embodiment of the present disclosure;
FIG. 4 is a schematic structural diagram of an apparatus for processing audio according to an embodiment of the present disclosure; and
FIG. 5 is a schematic structural diagram of an electronic device according to an embodiment of the present disclosure.

## DETAILED DESCRIPTION

The embodiments of the present disclosure will be described in more detail below with reference to the accompanying drawings. While certain embodiments of the present disclosure are shown in the drawings, it is to be understood that the present disclosure may be implemented in various forms, and should not be construed as limited to the embodiments set forth herein. On the contrary, those embodiments are provided for the thorough and complete understanding of the present disclosure. It should be understood that the drawings and embodiments of the present disclosure are for example purposes only and are not intended to limit the scope of the present disclosure.

It should be understood that various steps described in method implementations of the present disclosure may be performed in different order and/or in parallel. Furthermore, method implementations may include additional steps and/or omit steps that are shown. The scope of the present disclosure is not limited in this regard.

The terms "comprise" and its variants used herein are to be read as open terms that mean "include, but is not limited to". The term "based on" is to be read as "based at least in part on". The term "one embodiment" is to be read as "at least one embodiment", the term "another embodiment" is to be read as "at least one another embodiment", and the term "some embodiments" is to be read as "at least some embodiments". The relevant definitions of other terms will be given below.

It should be noted that the concepts of "first", "second" and the like mentioned in the disclosure are only used to distinguish between different apparatuses, modules or units, rather than limiting the order or interdependence of the functions performed by these apparatuses, modules or units.

It should be noted that modifications "one" and "more" mentioned in the present disclosure are examples but not limiting, and should be understood as "one or more" to those skilled in the art unless otherwise specified.

Names of messages or information exchanged between the plurality of apparatuses in implementations of the present disclosure are used for illustrative purposes only and are not intended to limit the scope of those messages or information.

The method of audio processing provided in the embodiments of this application is described in detail below with reference to the accompanying drawings.

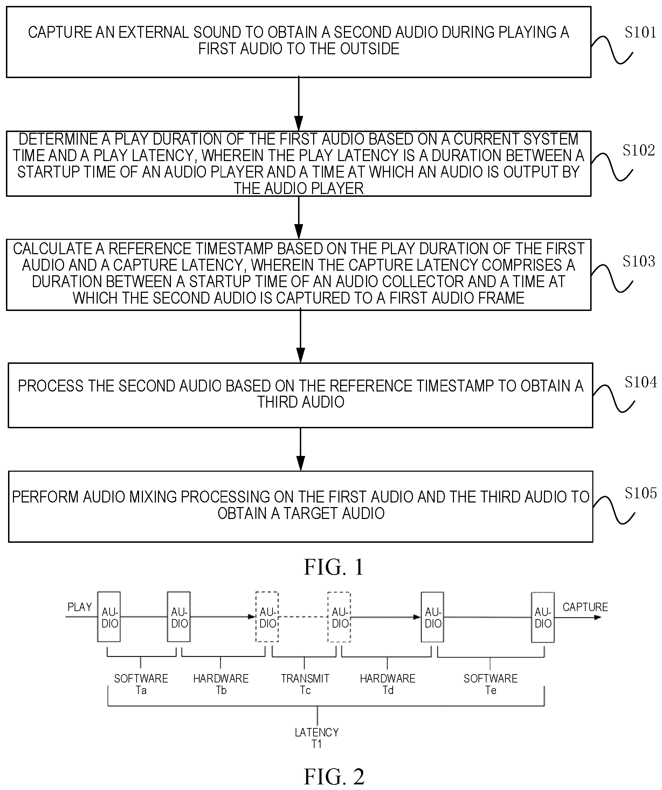

FIG. 1 is a flowchart of the method of audio processing according to an embodiment of the present disclosure. This embodiment can be applied to reduce the impact of latency during mixing processing. The method may be executed by an audio processing apparatus. The audio processing apparatus may be implemented in software and/or hardware, and may be configured in an electronic device. The electronic device includes an intelligent terminal with a photographing function, including a smartphone, a notebook computer, a tablet computer, a digital camera/video camera, a game device, and the like. Optionally, the intelligent terminal includes a touch screen.

As shown in FIG. 1, the method of audio processing provided by the embodiment of the present disclosure mainly includes the following steps:

S101: capturing an external sound to obtain a second audio during playing a first audio to the outside.

In some specific scenarios or applications, a mixture of two types of audios is required to achieve a certain purpose. For example, when shooting short videos, background music creates a certain atmosphere, and then the audio read out by the user is captured by a recording device of the user to express the user. Alternatively, in a karaoke application, a song accompaniment is played, and a singing audio of a user is captured, and finally the song accompaniment and singing audio are aligned and merged into a complete song.

Specifically, there may be a play latency between the time when the audio playing instruction is received from the user terminal and the time when the audio is output by the audio playing apparatus of the user terminal. In addition, there may be a capture latency between the time when the audio recording instruction is received from the user terminal and the time when a first audio frame is captured by the audio capturing apparatus.

In the embodiment of the present disclosure, the first audio may be understood as an audio played by a speaker of the user terminal. Optionally, the first audio may refer to a background music (BGM) or a song accompaniment audio. The second audio refers to an audio formed by an external sound captured by the user terminal.

In an implementation of the present disclosure, the first audio is played by the audio playing apparatus of the user terminal, and the second audio is captured by the audio capturing apparatus of the user terminal, wherein the audio capturing apparatus may be one or more of a pickup, a microphone, and the like.

In a specific embodiment of the present disclosure, in a karaoke scenario, in response to a trigger operation performed by a user on a recording control in a karaoke application, an audio playing apparatus of the user terminal plays a song accompaniment, meanwhile an audio capturing apparatus of the user terminal captures external sound data to obtain a second audio. Alternatively, in the video recording scenario, in response to the trigger operation performed by the user on the recording control in the video recording application, the audio playing apparatus of the user terminal plays the background music, meanwhile the audio capturing apparatus of the user terminal captures the external sound data to obtain the second audio.

S102: determining a play duration of the first audio based on a current system time and a play latency, wherein the play latency is a duration between a startup time of an audio player and a time at which an audio is output by the audio player.

In the embodiment of the present disclosure, the system time refers to the time displayed by the system of the user terminal, and the current system time may be understood as the running time of the system captured at the current time instant. The current system time refers to a time point.

In the embodiments of the present disclosure, a latency parameter in the present disclosure is first introduced. As shown in FIG. 2, the latency $T1$ of the whole process from receiving the audio playing instruction to capturing the audio mainly comprises: a play latency, a transmit latency $Tc$, and a capture latency. The play latency includes a play software latency $Ta$ and a play hardware latency $Tb$, and the capture latency comprises: a capture software latency $Te$ and a capture hardware latency $Td$. It should be noted that, the transmit latency $Tc$ is so small that its influence on the mixture of two audios is not considered in the embodiments of the present disclosure.

In an embodiment of the present disclosure, the play latency is a duration between the time when a playing instruction of an audio frame is received and the time when the audio frame is output by the audio player. The playing instruction of the audio frame being received may be: the playing instruction of the current audio frame is automatically generated and received after the playing instruction of the previous audio frame. For example, after the playing instruction of the Nth audio frame, the playing instruction of the (N+1)th audio frame is automatically generated and received. The playing instruction of the audio frame being received further includes: after the audio player starting instruction, a playing instruction of the first audio frame is received. The audio player starting instruction is input by the user through the user terminal, for example, pressing a physical key provided on the user terminal, or touching a start control displayed in an interface of the user terminal.

In one embodiment of the present disclosure, in the karaoke application, if the user sets the playing background music and detects the triggering operation of the user on the recording control, the audio player starting instruction is received.

In an embodiment of the present disclosure, a difference between a time instant at which a first audio frame is output by the audio player and a time instant at which a playing instruction of a first audio frame is received is used as a play latency.

At the time instant the audio player outputs the first audio frame, the state of the audio player is monitored by using the audio monitoring device, and when the first audio frame in the first audio output by the audio player is monitored, the system time at this time is obtained as the time instant at which the audio player outputs the first audio frame.

In an implementation of the disclosure, the play latency comprises a play software latency and a play hardware latency. The play software latency is a buffer write cycle of the audio player, and the play hardware latency is determined by a system latency function.

Specifically, the play software latency Ta is a duration in which the audio player receives an audio frame and writes the audio frame into the play buffer. The audio frames in the play buffer are sent to the play hardware device for play. The play software latency Ta is one buffer write cycle of the audio player. The play hardware latency Tb is the duration between the audio player hardware device receives the audio signal and the audio player hardware device outputs the audio, and the play hardware latency Tb can be obtained by the hardware latency function evaluation in the audio system. For example, the algorithm "AudioSystem: getOutputLatency". It should be noted that the algorithm provided by the present disclosure is merely an example, and a specific algorithm is not specifically limited.

Specifically, the buffer is a reserved storage space of the memory space of the device. Such storage spaces are used to buffer input or output data, and the purpose of the buffer is to reduce the number of reads and writes of the disk. The operation of the computer on the buffer is much faster than the operation on the disk, which can improve the running speed of the computer. The play software latency is a buffer write cycle of the audio player, which may be understood as the time consumed by the computer to write the buffer of the audio player during the stable operation of the audio player.

In an implementation of the disclosure, determining the play duration of the first audio based on the current system time and the play latency comprises: calculating a first difference between the current system time and a stable time instant of the audio player; and using a second difference between the first difference and the play latency as the play duration of the first audio.

In the embodiment of the present disclosure, the first difference between the current system time and the stable time instant of the audio player is calculated, that is, the duration between the stable time instant of the audio player and the current time instant of the current system is counted. Specifically, when the audio player is at a stable time instant, the timer starts timing from 0, the time corresponding to the current system time is obtained, and the timing duration of the timer is used as the first difference. Alternatively, the stable instant of the audio player is subtracted from the current system time to obtain a first difference.

Further, a second difference between the first difference and the play latency is used as the play duration of the first audio. The stable time instant of the audio player may be understood as the time instant at which the audio player can be in a stable state after cold start of the audio player.

In an implementation of the disclosure, the duration between the current system time and the time instant at which the audio player outputs the first audio frame in the first audio is used as the first play duration. Specifically, at the time instant the audio player outputs the first audio frame, the timer starts timing from 0 to obtain the time corresponding to the current system time. At this time, the timing duration of the timer is used as the play duration of the first audio.

In an implementation of the present disclosure, in an actual application, the audio mixing is an online real-time processing process. Thus, the current system time may be understood as a time instant at which the system captures the current audio frame in the second audio frame.

S103: calculating a reference timestamp based on the play duration of the first audio and a capture latency, wherein the capture latency comprises a duration between a startup time of an audio collector and a time at which the second audio is captured to a first audio frame.

In an implementation of the disclosure, the capture latency comprises: a capture software latency and a capture hardware latency; the capture software latency is a write cycle of a buffer of the audio collector, and the capture hardware latency is determined by a timestamp corresponding to an audio frame included in the second audio.

Specifically, the capture software latency Te is the duration between the audio is captured to the audio signal and the recording is stored, and is about one buffer write cycle of the audio collector; the capture hardware latency Td may be understood as the startup stable duration of the audio collector hardware, and is obtained by using the time extraction function in this disclosure. The capture latency is the sum of the capture software latency Te and the capture hardware latency Td.

The capture software latency is one buffer write cycle of the audio collector, which may be understood as the time consumed by the computer to write the buffer of the audio collector once during the stable operation of the audio collector. The capture hardware latency mainly refers to a duration between a hardware device in an audio collector monitors the audio signal to process the audio signal to obtain an audio signal that meets a write condition. It is obtained by a system algorithm in the embodiments of the disclosure, such as, an algorithm "AudioRecord#getTimestamp". It should be noted that the algorithm provided in the disclosure is merely an example, and a specific algorithm is not specifically limited.

In an implementation of the present disclosure, wherein calculating the reference timestamp based on the play duration of the first audio and the capture latency comprises: calculating a second difference between the play duration of the first audio and the capture latency; and using the second difference as the reference timestamp.

The reference timestamp may be understood as a timestamp having a reference meaning when performing audio mixing processing on the captured audio.

In an implementation of the disclosure, calculating the reference timestamp based on the play duration of the first audio and the capture latency comprises: calculating a second difference between the play duration of the first audio and the capture latency; and using the second difference as the reference timestamp.

In the embodiment of the disclosure, the capture latency is subtracted from the play duration of the first audio obtained in the above step to obtain a time point, which is used as a reference timestamp.

In the embodiment of the disclosure, the influence of the capture latency on the whole latency process is optimized through calculating the reference timestamp by the capture latency.

S104: processing the second audio based on the reference timestamp to obtain a third audio.

In the embodiment of the disclosure, the reference timestamp is data having reference significance, obtained by calculation with processing on the second audio in the foregoing embodiment.

In this embodiment of the disclosure, the second audio obtained by capturing the external sound comprises one or more audio frames, and for each audio frame, processing is performed in the manner in step S102 and step S103, to obtain a correspondence between each audio frame and the reference timestamp.

In an implementation of the disclosure, processing the second audio based on the reference timestamp to obtain the third audio comprises: determining a correspondence between the reference timestamp and the audio frame; performing packet dropout processing on the audio frame corresponding to the reference timestamp in accordance with the reference timestamp being less than zero; and using the audio frame corresponding to the reference timestamp equal to or greater than zero as the third audio in accordance with the reference timestamp being equal to or greater than zero.

In an implementation of the disclosure, according to the calculated correspondence between the audio frame and the reference timestamp, packet dropout processing is performed on the corresponding audio frame when the reference timestamp is less than zero, that is, no audio mixing processing is performed.

Specifically, according to the calculated correspondence between the audio frame and the reference timestamp, when the reference timestamp is greater than or equal to zero, the audio frame corresponding to the reference timestamp greater than or equal to zero is used as the third audio frame. Specifically, when the reference timestamp is equal to 0, the corresponding audio frame is used as the first audio frame of the third audio. When the reference timestamp is greater than 0, the corresponding audio frames are arranged in ascending order of the reference timestamps as the audio frames of the third audio.

S105: performing audio mixing processing on the first audio and the third audio to obtain a target audio.

The target audio is audio obtained after the first audio and the third audio are mixed. Specifically, after the first audio frame of the first audio and the first audio frame of the third audio are aligned, the subsequent audio is mixed to obtain the target audio.

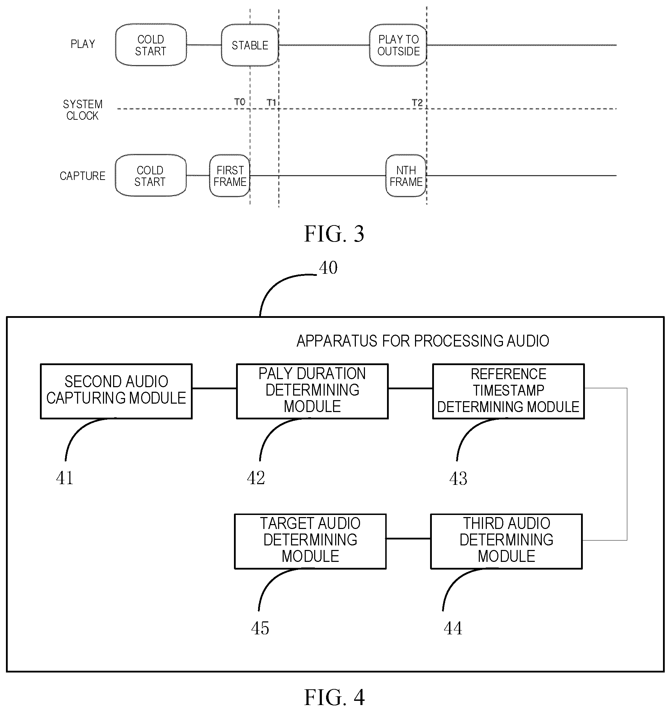

In a specific implementation of the disclosure, as shown in FIG. 3, when the first audio is played, the audio player has a cold start process after receiving the start instruction, so that the audio player reaches a stable play state. As shown in FIG. 3, when the audio player reaches the stable play state, the time point of the system clock is marked as the stable time instant T1 of the audio player, and the time instant at which the hardware device (for example, the loudspeaker, the speaker, etc.) of the audio player outputs the first audio frame is marked as T2. After the cold start, the collection player starts to capture external sound to obtain second audio, wherein a system clock corresponding to a first audio frame of the second audio is T0.

In the embodiment of the disclosure, from the time instant T2 at which the audio player outputs the first audio frame, the timer starts timing from 0, and the timing duration Tplay of the timer is the play duration of the first audio.

$$\text{Tplay} = T - T2 = T - T1 - \text{Tplay\_latency} \qquad (1)$$

where T is the current system time, and Tplay_latency is the play latency.

In an embodiment of the disclosure, a time when the audio collector captures an audio frame in the second audio is Tsys_capture.

$$Tsys\_capture = T\text{-}Tcapture\_latency \quad (2)$$

where Tcapture_latency is an acquire latency.

The above formula (1) and formula (2) are jointly calculated to obtain the reference timestamp Tcapture:

$$Tcapture = Tplay - Tcapture\_latency \qquad (3)$$

Finally, the reference timestamp Tcapture is used as the timestamp of the second audio. If the reference timestamp Tcapture< 0, the audio frame is discarded and not encoded. If the reference timestamp is equal to 0, the corresponding audio frame is used as the first audio frame of the third audio, and is aligned with the first audio frame of the first audio. Then the first audio and the third audio are encoded to obtain the target audio.

FIG. 4 is a schematic structural diagram of an apparatus for processing audio according to an embodiment of the present disclosure. This embodiment is applicable to audio processing, and the apparatus for processing audio may be implemented in software and/or hardware. The apparatus for processing audio may be configured in an electronic device. The electronic device comprises an intelligent terminal with an audio processing function, including a smart phone, a notebook computer, a tablet computer, a digital camera/video camera, a game device, and the like. Optionally, the smart terminal includes a touch screen.

As shown in FIG. 4, the apparatus 40 for processing audio provided by the embodiment of the disclosure mainly comprises: a second audio capturing module 41, a play duration determining module 42, a reference timestamp determining module 43, a third audio determining module 44, and a target audio determining module 45.

wherein, the second audio capturing module 41 is configured to capture an external sound to obtain a second audio during playing a first audio to the outside;

the play duration determining module 42 is configured to determine a play duration of the first audio based on a current system time and a play latency, wherein the play latency is a duration between a startup time of an audio player and a time at which an audio is output by the audio player;

the reference timestamp determining module 43 is configured to calculate a reference timestamp based on the play duration of the first audio and a capture latency, wherein the capture latency comprises a duration between a startup time of an audio collector and a time at which the second audio is captured to a first audio frame;

the third audio determining module 44 is configured to process the second audio based on the reference timestamp to obtain a third audio;

the target audio determining module 45 is configured to perform audio mixing processing on the first audio and the third audio to obtain a target audio.

The embodiment of the disclosure provides an apparatus for processing audio, which is used for executing the following processes: capturing an external sound to obtain a second audio during playing a first audio to the outside; determining a play duration of the first audio based on a current system time and a play latency, wherein the play latency is a duration between a startup time of an audio player and a time at which an audio is output by the audio player; calculating a reference timestamp based on the play duration of the first audio and a capture latency, wherein the capture latency comprises a duration between a startup time of an audio collector and a time at which the second audio is captured to a first audio frame; processing the second audio based on the reference timestamp to obtain a third audio; and performing audio mixing processing on the first audio and the third audio to obtain a target audio. According to the technical scheme provided by the disclosure, the influence of the latency on the audio is optimized during mixing the first audio and the second audio, so that the played first audio and the recorded second audio are synchronized, the influence of the latency on the audio listening is reduced, and the karaoke experience of the user is improved.

In a possible implementation, the play latency comprises a play software latency and a play hardware latency, the play software latency is a buffer write cycle of the audio player, and the play hardware latency is determined by a system latency function.

In a possible implementation, the capture latency comprises: a capture software latency and a capture hardware latency; the capture software latency is a write cycle of a buffer of the audio collector, and the capture hardware latency is determined by a timestamp corresponding to an audio frame included in the second audio.

In a possible implementation, the second audio comprises at least one or more audio frames, and the third audio determining module 44 comprises: a correspondence determining unit, configured to determine a correspondence between the reference timestamp and the audio frame; a first processing unit, configured to perform packet dropout processing on the audio frame corresponding to the reference timestamp in accordance with the reference timestamp being less than zero; and a second processing unit, configured to use the audio frame corresponding to the reference timestamp equal to or greater than zero as the third audio in accordance with the reference timestamp being equal to or greater than zero.

In a possible implementation, the play duration determining module 42 comprises: a first difference calculating unit, configured to calculate a first difference between the current system time and a stable time instant of the audio player; and a second difference calculating unit, configured to use a second difference between the first difference and the play latency as the play duration of the first audio.

In a possible implementation, the conference timestamp determining module 43 is specifically configured to calculate a second difference between the play duration of the first audio and the capture latency; and use the second difference as the reference timestamp.

The apparatus for processing audio provided in the embodiments of the disclosure may perform the steps performed in the method of audio processing provided in the embodiments of the disclosure, and the steps and beneficial effects are not repeated herein.

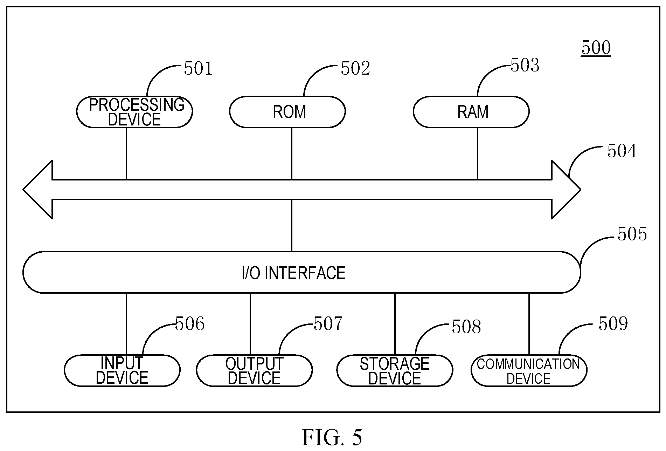

FIG. 5 is a schematic structural diagram of an electronic device according to an embodiment of the disclosure. With specific reference to FIG. 5, which is a schematic structural diagram of an electronic device 500 suitable for implementing the embodiments of the disclosure. The electronic device 500 in the embodiments of the disclosure may comprise, without limitation, to, a mobile terminal such as a mobile phone, a notebook computer, a digital broadcast receiver, a PDA (personal digital assistant), a PAD (tablet computer), a PMP (portable multimedia player), an on-board terminal (for example, on-board navigation terminal), a wearable terminal device, and the like, as well as a fixed terminal such as a digital TV, a desktop computer, a smart home device, or the like. The electronic device shown in FIG. 5 is merely an example, and should not impose any limitation on the functions and use scope of the embodiments of the present disclosure.

As shown in FIG. 5, the electronic device 500 may comprise a processing device (for example, a central processor, a graphics processor, etc.) 501, which may perform various appropriate actions and process according to a program stored in a read-only memory (ROM) 502 or a program loaded into a random access memory (RAM) 503 from a storage device 508 to implement the picture rendering method according to the embodiments of the present disclosure. In RAM 503, there are also stored various programs and data required by the terminal device 500 when operating. The processing devices 501, ROM 502 and RAM 503 are connected to each other via a bus 504. Input/output (I/O) interface 505 is also connected to bus 504.

Usually, the following devices may be connected to the I/O interface 505: an input device 506 including, for example, a touch screen, a touchpad, a keyboard, a mouse, a camera, a microphone, an accelerometer, a gyroscope, or the like; an output device 507 including, for example, a liquid crystal display (LCD), a speaker, a vibrator, or the like; a storage device 1008 including, for example, a magnetic tape, a hard disk, or the like; and a communication device 509. The communication device 509 may allow the terminal device 500 to communicate wirelessly or wired with other devices to exchange data. While FIG. 5 shows a terminal device 500 with various devices, it should be understood that it is not required to implement or have all of the illustrated devices. Alternatively, more or fewer devices may be implemented or provided.

In particular, according to an embodiment of the present disclosure, the process described above with reference to the flowchart may be implemented as a computer software program. For example, the embodiments of the present disclosure comprise a computer program product comprising a computer program embodied on a non-transitory computer readable medium, the computer program comprising program code for performing the method shown in the flowchart to implement the page jump method as described above. In such embodiments, the computer program may be downloaded and installed from the network through the communication device 509, or installed from the storage device 508, or installed from the ROM 502. The computer program, when executed by the processing device 501, perform the foregoing functions defined in the method of the embodiments of the present disclosure.

It should be noted that the computer-readable medium described above may be a computer readable signal medium, a computer readable storage medium, or any combination thereof. The computer-readable storage medium may be, for example, but not limited to, an electrical, magnetic, optical, electromagnetic, infrared, or semiconductor system, apparatus, or device, or any combination thereof. More specific examples of computer-readable storage media may include, but are not limited to, an electrical connection with one or more wires, a portable computer diskette, a hard disk, a random access memory (RAM), a read-only memory (ROM), an erasable programmable read-only memory (EPROM or flash memory), an optical fiber, a portable compact disk read-only memory (CD-ROM), an optical storage device, a magnetic storage device, or any suitable combination of the foregoing. In the present disclosure, a computer-readable storage medium may be any tangible medium containing or storing a program that may be used by or in conjunction with an instruction execution system, apparatus or device. In the present disclosure, a computer readable signal medium may include a data signals propagated in baseband or as part of a carrier, wherein the computer readable program code is carried. Such propagated data signals may take a variety of forms including, but not limited to, electromagnetic signals, optical signals, or any suitable combination of the foregoing. The computer readable signal medium may also be any computer readable medium other than a computer readable storage medium that may send, propagate, or transmit a program for use by or in connection with an instruction execution system, apparatus, or device. The program code embodied on the computer-readable medium may be transmitted with any suitable medium, including, but not limited to, wires, optical cables, RF (radio frequency), and the like, or any suitable combination of the foregoing.

In some implementations, the client and server may communicate using any currently known or future developed network protocol, such as HTTP (HyperText Transfer Protocol), and may be interconnected with any form or medium of digital data communication (e.g., a communication network). Examples of communication networks include local area networks ("LANs"), wide area networks ("WANs"), inter-networks (e.g., the Internet), and peer-to-peer networks (e.g., ad hoc peer-to-peer networks), as well as any currently known or future developed networks.

The above computer-readable medium may be contained in the electronic device; or may be separately present without being assembled into the electronic device.

The above computer readable medium carries one or more programs which, when executed by the terminal device, cause the terminal device to: capture an external sound to obtain a second audio during playing a first audio to the outside; determine a play duration of the first audio based on a current system time and a play latency, wherein the play latency is a duration between a startup time of an audio player and a time at which an audio is output by the audio player; calculate a reference timestamp based on the play duration of the first audio and a capture latency, wherein the capture latency comprises a duration between a startup time of an audio collector and a time at which the second audio is captured to a first audio frame; process the second audio based on the reference timestamp to obtain a third audio; and perform audio mixing processing on the first audio and the third audio to obtain a target audio.

Optionally, when the one or more programs are executed by the terminal device, the terminal device may further perform other steps described in the foregoing embodiments.

Computer program code for performing the operations of the present disclosure may be written in one or more programming languages or the combination thereof, which include without limitation to object oriented programming languages such as Java, Smalltalk, C++, and conventional procedural programming languages, such as the "C" language or similar programming languages. The program code may execute entirely on a user's computer, partly on a user's computer, as a stand-alone software package, partly on a user's computer and partly on a remote computer, or entirely on a remote computer or server. In the case of a remote computer, the remote computer may be connected to the user's computer through any kind of network, including a local area network (LAN) or a wide area network (WAN), or may be connected to an external computer (e.g., connected through the Internet using an Internet service provider).

The flowcharts and block diagrams in the figures illustrate architecture, functionality, and operation of possible implementations of systems, methods, and computer program products according to various embodiments of the present disclosure. In this regard, each block in the flowchart or block diagram may represent a module, program segment, or portion of code that includes one or more executable instructions for implementing the specified logical function. It should also be noted that in some alternative implementations, the functions noted in the blocks may also occur in a different order than that illustrated in the figures. For example, two blocks shown in succession may actually be executed substantially in parallel, which may sometimes be performed in the reverse order, depending on the functionality involved. It is also noted that each block in the block diagrams and/or flowcharts, as well as combinations of blocks in the block diagrams and/or flowcharts, may be implemented with a dedicated hardware-based system that performs the specified functions or operations, or may be implemented in a combination of dedicated hardware and computer instructions.

The units involved in the embodiments of the present disclosure may be implemented in software or hardware. The name of the unit does not constitute any limitation on the unit itself in some cases.

The functions described above may be performed, at least in part, by one or more hardware logic components. For example, without limitation, example types of hardware logic components that may be used may include: field programmable gate arrays (FPGAs), application specific integrated circuits (ASICs), application specific standard products (ASSPs), system-on-chips (SOCs), complex programmable logic devices (CPLDs), and the like.

In the context of the present disclosure, a machine-readable medium may be a tangible medium that may contain or store a program for use by or in connection with an instruction execution system, apparatus, or device. The machine-readable medium may be a machine-readable signal medium or a machine-readable storage medium. The machine-readable medium may include, but is not limited to, electronic, magnetic, optical, electromagnetic, infrared, or semiconductor systems, apparatuses or devices, or any suitable combination of the foregoing. More specific examples of machine-readable storage media may include electrical connections based on one or more wires, a portable computer disk, a hard disk, a random access memory (RAM), a read-only memory (ROM), an erasable programmable read-only memory (EPROM or flash memory), an optical fiber, a portable compact disc read-only memory (CD-ROM), an optical storage device, a magnetic storage device, or any suitable combination of the foregoing.

According to one or more embodiments of the present disclosure, the present disclosure provides a method of audio processing, comprising: capturing an external sound to obtain a second audio during playing a first audio to the outside; determining a play duration of the first audio based on a current system time and a play latency, wherein the play latency is a duration between a startup time of an audio player and a time at which an audio is output by the audio player; calculating a reference timestamp based on the play duration of the first audio and a capture latency, wherein the capture latency comprises a duration between a startup time of an audio collector and a time at which the second audio is captured to a first audio frame; processing the second audio based on the reference timestamp to obtain a third audio; and performing audio mixing processing on the first audio and the third audio to obtain a target audio.

According to one or more embodiments of the present disclosure, the present disclosure provides an apparatus for processing video and audio, comprising: a second audio capturing module, configured to capture an external sound to obtain a second audio during playing a first audio to the outside; a play duration determining module, configured to determine a play duration of the first audio based on a current system time and a play latency, wherein the play latency is a duration between a startup time of an audio player and a time at which an audio is output by the audio player; a reference timestamp determining module, configured to calculate a reference timestamp based on the play duration of the first audio and a capture latency, wherein the capture latency comprises a duration between a startup time of an audio collector and a time at which the second audio is captured to a first audio frame; a third audio determining module, configured to process the second audio based on the reference timestamp to obtain a third audio; and a target audio determining module, configured to perform audio mixing processing on the first audio and the third audio to obtain a target audio.

According to one or more embodiments of the present disclosure, the present disclosure provides an electronic device, comprising:

one or more processors;
a memory, configured to store one or more programs;
the one or more programs, when executed by the one or more processors, cause the one or more processors to implement any method of audio processing provided by the disclosure.

According to one or more embodiments of the present disclosure, the present disclosure provides a computer-readable storage medium having a computer program stored thereon, wherein the computer program, when executed by a processor, implements any method of audio processing provided by the disclosure.

According to one or more embodiments of the present disclosure, the present disclosure provides a computer program product, comprising a computer program or instructions, wherein the computer program or instructions, when executed by a processor, implements any method of audio processing provided by the disclosure.

The above description is merely an illustration of the preferred embodiments of the present disclosure and the principles of the application. Those skilled in the art should understand that the disclosure scope involved therein is not limited to the technical solutions formed from a particular combination of the above technical features, but should also cover other technical solutions formed by any combination of the above technical features or their equivalent features without departing from the above disclosure concepts, e.g., technical solutions formed by replacing the above features with technical features having similar functions disclosed (without limitation) in the present disclosure.

In addition, although various operations have been depicted in a particular order, it should not be construed as requiring that the operations be performed in the particular order shown or in sequential order of execution. Multitasking and parallel processing may be advantageous in certain environments. Likewise, although the foregoing discussion includes several specific implementation details, they should not be construed as limiting the scope of the present disclosure. Some features described in the context of separate embodiments may also be realized in combination in a single embodiment. On the contrary, various features described in the context of a single embodiment may also be realized in a plurality of embodiments, either individually or in any suitable sub-combinations.

While the present subject matter has been described using language specific to structural features and/or method logic actions, it should be understood that the subject matter defined in the appended claims is not necessarily limited to the particular features or actions described above. On the contrary, the particular features and actions described above are merely example forms of realizing the claims.

**Claims**

1. A method of processing audio, wherein the method comprises:

capturing an external sound to obtain a second audio during playing a first audio to the outside;
determining a play duration of the first audio based on a current system time and a play latency, wherein the play latency is a duration between a startup time of an audio player and a time at which an audio is output by the audio player;
calculating a reference timestamp based on the play duration of the first audio and a capture latency, wherein the capture latency comprises a duration between a startup time of an audio collector and a time at which the second audio is captured to a first audio frame;
processing the second audio based on the reference timestamp to obtain a third audio; and
performing audio mixing processing on the first audio and the third audio to obtain a target audio.

2. The method of claim 1, wherein the play latency comprises a play software latency and a play hardware latency, the play software latency is a buffer write cycle of the audio player, and the play hardware latency is determined by a system latency function.

3. The method of claim 1, wherein the capture latency comprises: a capture software latency and a capture hardware latency; the capture software latency is a write cycle of a buffer of the audio collector, and the capture hardware latency is determined by a timestamp corresponding to an audio frame included in the second audio.

4. The method of claim 1, wherein the second audio comprises at least one or more audio frames, and processing the second audio based on the reference timestamp to obtain the third audio comprises:

   determining a correspondence between the reference timestamp and the audio frame;
   performing packet dropout processing on the audio frame corresponding to the reference timestamp in accordance with the reference timestamp being less than zero; and
   using the audio frame corresponding to the reference timestamp equal to or greater than zero as the third audio in accordance with the reference timestamp being equal to or greater than zero.

5. The method of claim 1, wherein determining the play duration of the first audio based on the current system time and the play latency comprises:

   calculating a first difference between the current system time and a stable time instant of the audio player; and
   using a second difference between the first difference and the play latency as the play duration of the first audio.

6. The method of claim 1, wherein calculating the reference timestamp based on the play duration of the first audio and the capture latency comprises:

   calculating a second difference between the play duration of the first audio and the capture latency; and
   using the second difference as the reference timestamp.

7. An apparatus for processing video and audio, comprising:

   a second audio capturing module, configured to capture an external sound to obtain a second audio during playing a first audio to the outside;
   a play duration determining module, configured to determine a play duration of the first audio based on a current system time and a play latency, wherein the play latency is a duration between a startup time of an audio player and a time at which an audio is output by the audio player;
   a reference timestamp determining module, configured to calculate a reference timestamp based on the play duration of the first audio and a capture latency, wherein the capture latency comprises a duration between a startup time of an audio collector and a time at which the second audio is captured to a first audio frame;
   a third audio determining module, configured to process the second audio based on the reference timestamp to obtain a third audio; and
   a target audio determining module, configured to perform audio mixing processing on the first audio and the third audio to obtain a target audio.

8. An electronic device, wherein the electronic device comprises:

   one or more processors;
   a storage device, configured to store one or more programs;
   the one or more programs, when executed by the one or more processors, cause the one or more processors to implement the method of any of claims 1 to 6.

9. A computer-readable storage medium having a computer program stored thereon, wherein the computer program, when executed by a processor, implements the method of any of claims 1 to 6.

**10.** A computer program product, comprising a computer program or instructions, wherein the computer program or instructions, when executed by a processor, implements the method of any of claims 1 to 6.

| | |
|---|---|
| CAPTURE AN EXTERNAL SOUND TO OBTAIN A SECOND AUDIO DURING PLAYING A FIRST AUDIO TO THE OUTSIDE | S101 |
| DETERMINE A PLAY DURATION OF THE FIRST AUDIO BASED ON A CURRENT SYSTEM TIME AND A PLAY LATENCY, WHEREIN THE PLAY LATENCY IS A DURATION BETWEEN A STARTUP TIME OF AN AUDIO PLAYER AND A TIME AT WHICH AN AUDIO IS OUTPUT BY THE AUDIO PLAYER | S102 |
| CALCULATE A REFERENCE TIMESTAMP BASED ON THE PLAY DURATION OF THE FIRST AUDIO AND A CAPTURE LATENCY, WHEREIN THE CAPTURE LATENCY COMPRISES A DURATION BETWEEN A STARTUP TIME OF AN AUDIO COLLECTOR AND A TIME AT WHICH THE SECOND AUDIO IS CAPTURED TO A FIRST AUDIO FRAME | S103 |
| PROCESS THE SECOND AUDIO BASED ON THE REFERENCE TIMESTAMP TO OBTAIN A THIRD AUDIO | S104 |
| PERFORM AUDIO MIXING PROCESSING ON THE FIRST AUDIO AND THE THIRD AUDIO TO OBTAIN A TARGET AUDIO | S105 |

FIG. 1

FIG. 2

FIG. 3

FIG. 4

FIG. 5

## INTERNATIONAL SEARCH REPORT

| International application No. |
|---|
| **PCT/CN2023/125428** |

### A. CLASSIFICATION OF SUBJECT MATTER

G10H1/36(2006.01)i

According to International Patent Classification (IPC) or to both national classification and IPC

### B. FIELDS SEARCHED

Minimum documentation searched (classification system followed by classification symbols)

IPC:G10H1

Documentation searched other than minimum documentation to the extent that such documents are included in the fields searched

Electronic data base consulted during the international search (name of data base and, where practicable, search terms used)

CNABS, CNTXT, 百度, BAIDU, CNKI, 万方, WANFANG: 音频, 伴奏, 同步, 播放, 延迟, 延时, 时延, 混音, 混合, 对齐, 时间戳, 采集, 录制, 录音, 传输, K歌; DWPI, VEN, USTXT, EPTXT, IEEE, ELSEVIERSCIENCE: audio, accompaniment, synchronization, synchronously, play, delay, mix, latency, time stamp, gather, collect, rec, record, transmit, karaoke

### C. DOCUMENTS CONSIDERED TO BE RELEVANT

| Category* | Citation of document, with indication, where appropriate, of the relevant passages | Relevant to claim No. |
|---|---|---|
| A | CN 113948054 A (BEIJING POBIZHE TECHNOLOGY CO., LTD.) 18 January 2022 (2022-01-18)<br>description, paragraphs 4-160, and figures 1-10 | 1-10 |
| A | CN 110931053 A (GUANGZHOU KUGOU COMPUTER TECHNOLOGY CO., LTD.) 27 March 2020 (2020-03-27)<br>description, paragraphs 5-163, and figures 1-8 | 1-10 |
| A | CN 104392711 A (GUIYANG LONGMASTER INFORMATION & TECHNOLOGY CO., LTD.) 04 March 2015 (2015-03-04)<br>entire document | 1-10 |
| A | JP 2016206575 A (DAIICHIKOSHO CO., LTD.) 08 December 2016 (2016-12-08)<br>entire document | 1-10 |
| A | WO 2022030750 A1 (SAMSUNG ELECTRONICS CO., LTD.) 10 February 2022 (2022-02-10)<br>entire document | 1-10 |

☐ Further documents are listed in the continuation of Box C.　☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **02 January 2024** | **04 January 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

| International application No. |
| --- |
| **PCT/CN2023/125428** |

| Patent document cited in search report | | | Publication date (day/month/year) | Patent family member(s) | | | Publication date (day/month/year) |
| --- | --- | --- | --- | --- | --- | --- | --- |
| CN | 113948054 | A | 18 January 2022 | None | | | |
| CN | 110931053 | A | 27 March 2020 | CN | 110931053 | B | 08 October 2021 |
| CN | 104392711 | A | 04 March 2015 | None | | | |
| JP | 2016206575 | A | 08 December 2016 | JP | 6457326 | B2 | 23 January 2019 |
| WO | 2022030750 | A1 | 10 February 2022 | KR | 20220016552 | A | 10 February 2022 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211280550